# EUROPEAN PATENT APPLICATION

(11) **EP 4 142 153 A1**
(43) Date of publication of application: **01.03.2023**
(21) Application number: 21792954.6
(22) Date of filing: 20.04.2021
(51) Int. Cl.: H03H 9/58, H03H 9/17

(54) **BULK ACOUSTIC RESONATOR AND METHOD FOR DESIGNING SAME, FILTER AND ELECTRONIC DEVICE**

(30) Priority: 21.04.2020 CN 202010314859
(71) Applicant: ROFS MICROSYSTEM (TIANJIN) CO., LTD., Tianjin 300462 (CN)
(72) Inventor: ZHANG, Quande, Tianjin 300462 (CN); PANG, Wei, Tianjin 300072 (CN)
(74) Representative: Ström & Gulliksson AB
(86) International application number: PCT/CN2021/088484
(87) International publication number: WO 2021/213401

(57) **Abstract**

A bulk acoustic resonator, an effective region of which has an effective area. In the effective region, a second end point (32') of an input side (31), a first end point (34') of an output side (34), a second end point (35') of the output side (34) and a first end point (31') of the input side (31) are successively connected to each other to define a basic quadrilateral, and the area of the quadrilateral is not greater than the effective area; in a convex polygon, the length of the input side (31) and the length of the output side (34) are within a range from more than 1.5 times the equivalent side length to less than 2.5 times the equivalent side length, and the equivalent side length is the length of sides of a regular pentagon of which the area is equivalent to the effective area; an interior angle (b21) where the second end point (32') of the input side (31) of the convex polygon is located is within a range of greater than 90°C and not greater than 150°C, and the other interior angles (b22, b23, b24, b25, b26) of the convex polygon are within a range of not less than 60° and not greater than 150°C, and an obtuse angle (a3) formed by a basic input side and a basic output side is within a range of not less than 110° and not greater than 170°. The present disclosure also relates to a method for designing the resonator, a filter and an electronic device.

## Description

### TECHNICAL FIELD

Embodiments of the present disclosure relate to the field of semiconductors, and in particular, to a bulk acoustic wave resonator and a method for configuring the same, and an electronic device having the filter or the resonator.

### BACKGROUND

A bulk acoustic wave filter has the advantages of low insertion loss, high rectangular coefficient, high power capacity and the like, and thus is widely applied to the current wireless communication system and is an important component for determining the quality of a radio-frequency signal entering and exiting the communication system.

For example, the core component of the bulk acoustic wave device of the bulk acoustic wave filter is a resonator. When the bulk acoustic wave filter is designed, in general, developers perform layout on an internal resonator according to area requirements and an arranging sequence, and the shape of the resonator is configured according to the capabilities and experience of the developers.

However, the performance of the resonator has a direct relationship with the shape of the resonator. The unrestrained shape may cause a certain degree of degradation to the performance of the resonator, and the optimized shape of the resonator can significantly improve the performance of the resonator. In particular, the power capacity of the resonator has a great relationship to its shape. This is because the resonators with different shapes have different temperature characteristics, stress distributions, and electromagnetic acoustic boundaries even if the areas are the same, thereby determining that they have different power capacities.

It is particularly important to configure a high-power bulk acoustic wave filter by optimizing the shape of the resonator, so as to improve the power capacity of the resonator without changing other properties.

However, the current developers have no precise definition on the configuration of the shape of the resonator, which causes the randomness of the shape of the resonator and may make the final bulk acoustic wave filter unable to fully exert its performance advantages.

### SUMMARY

The present disclosure is provided to solve or improve at least one aspect of technical problems in the related art. The present disclosure improves the performance and design degree of freedom of a resonator by precisely defining the shape of an effective region of the bulk acoustic wave resonator.

According to one aspect of embodiments of the present disclosure, a bulk acoustic wave resonator is provided. The bulk acoustic wave resonator includes a substrate, an acoustic mirror, a bottom electrode, a top electrode, and a piezoelectric layer. An overlapping region of the acoustic mirror, the bottom electrode, the piezoelectric layer and the top electrode in a thickness direction of the resonator forms an effective region of the resonator, the effective region has an effective area, and the effective region has a shape of a convex polygon of which a number of edges is equal to or greater than four. The convex polygon is divided into a basic quadrilateral and at least one convex region and four edges of the basic quadrilateral are bottom edges of the at least one convex region, or the convex polygon is a basic quadrilateral. In the effective region, a second endpoint of an input side, a first endpoint of an output side, a second endpoint of the output side and a first endpoint of the input side are sequentially connected to each other to define the basic quadrilateral, the first endpoint and the second endpoint of the input side define a basic input edge, the first endpoint and the second endpoint of the output side define a basic output edge, and the basic quadrilateral has a quadrilateral area that is equal to or less than the effective area. In the convex polygon, a distance between the second endpoint of the input side and the first endpoint of the output side is less than a distance between the first endpoint of the input side and the second endpoint of the output side, an edge length of the input side and an edge length of the output side are in a range of 1.5 times an equivalent edge length to 2.5 times the equivalent edge length, and the equivalent edge length is an edge length of a regular pentagon of which an area is equal to the effective area. An inner angle where the second endpoint of the input side of the convex polygon is located is greater than 90° and equal to or less than 150°, other inner angles of the convex polygon are equal to or greater than 60° and equal to or less than 150°, and an obtuse angle formed by the basic input edge and the basic output edge is equal to or greater than 110° and equal to or less than 170°.

The embodiments of the present disclosure further relate to a method for configuring a bulk acoustic wave resonator. The resonator includes a substrate, an acoustic mirror, a bottom electrode, a top electrode, and a piezoelectric layer. An overlapping region of the acoustic mirror, the bottom electrode, the piezoelectric layer and the top electrode in a thickness direction of the resonator forms an effective region of the resonator, and the effective region has a shape of a convex polygon of which a number of edges is equal to or greater than four. The method includes:
determining an effective area of the effective region, and obtaining an equivalent edge length of the effective region, the equivalent edge length being an edge length of a regular pentagon of which an area is equal to the effective area; and
selecting positions of a first endpoint and a second endpoint of a basic input edge and selecting positions of a first endpoint and a second endpoint of a basic output edge to determine the basic quadrilateral,
wherein an edge length of an input side and an edge length of an output side are in a range of 1.5 times the equivalent edge length to 2.5 times the equivalent edge length, an obtuse angle formed by the basic input edge and the basic output edge is equal to or greater than 110° and equal to or less than 170°, and an quadrilateral area of the basic quadrilateral is equal to or less than the effective area;
wherein the first endpoint and the second endpoint of the basic input edge are the first endpoint and the second endpoint of the input side of the effective region, the first endpoint and the second endpoint of the basic output edge are the first endpoint and the second endpoint of the output side of the effective region, and a distance between the second endpoint of the input side and the first endpoint of the output side is less than a distance between the first endpoint of the input side and the second endpoint of the output side; and
wherein in the convex polygon, an inner angle where the second endpoint of the input side of the convex polygon is located is greater than 90° and equal to or less than 150°, and other inner angles of the convex polygon are equal to or greater than 60° and equal to or less than 150°.

The embodiments of the present disclosure further relate to a filter including at least one bulk acoustic wave resonators described above.

The embodiments of the present disclosure further relate to an electronic device including the above filter or resonator.

### BRIEF DESCRIPTION OF DRAWINGS

The following description and drawings may help understand these and other features and advantages in various embodiments of the present disclosure. The same reference signs in the drawings always indicate the same components.
FIG. 1 is a schematic diagram of an equivalent pentagon of an effective region of a bulk acoustic wave resonator.
FIG. 2 is a top view of an effective region of a bulk acoustic wave resonator according to an exemplary embodiment of the present disclosure.
FIG. 3 is a top view of an effective region of a bulk acoustic wave resonator according to another exemplary embodiment of the present disclosure.
FIG. 4 is a top view of an effective region of a bulk acoustic wave resonator according to yet another exemplary embodiment of the present disclosure.
FIG. 5 is a top view of an effective region of a bulk acoustic wave resonator according to yet another exemplary embodiment of the present disclosure.
FIG. 6 is a flow diagram of a method for configuring a bulk acoustic wave resonator according to an exemplary embodiment of the present disclosure.
FIG. 7 is a flow diagram showing steps of determining a basic quadrilateral in FIG. 6 according to an exemplary embodiment of the present disclosure.
FIG. 8 is a schematic diagram of a basic quadrilateral obtained by the configuring method shown in FIG. 7.
FIG. 9 is a schematic diagram of a minimum bottom-edge protruding area and a maximum bottom-edge protruding area, which may be present on two bottom edges of the basic quadrilateral in step 602 in FIG. 6.
FIG. 10 is a schematic diagram of a convex polygon of an effective region, which is obtained by the configuring method shown in FIG. 6, according to an embodiment of the present disclosure.
FIG. 11 is a schematic diagram of a convex polygon of an effective region, which is obtained by the configuring method shown in FIG. 6, according to another embodiment of the present disclosure.

### DESCRIPTION OF EMBODIMENTS

The technical solutions of the present disclosure will be further described below in detail through embodiments and in conjunction with the drawings. The same or similar reference signs indicate the same or similar components throughout the description. The following description of embodiments of the present disclosure with reference to the drawings is intended to explain the general inventive concept of the present disclosure, and should not be construed as limitation to the present disclosure.

A shape of an effective region of a bulk acoustic wave resonator according to the present disclosure may be a closed region, which is formed by connecting at least four edges end to end. The closed region is a convex polygon, and may be divided into a basic quadrilateral and a plurality of convex regions with four edges used as bottom edges. In a specific case, the closed region may be merely a basic quadrilateral. The basic quadrilateral determines a main contour of the effective region of the resonator. Two edges of the basic quadrilateral, for example, two long edges, form a basic input edge and a basic output edge of the effective region of the bulk acoustic wave resonator. Lengths of the two edges are both in a range of 1.5 times an equivalent edge length to 2.5 times the equivalent edge length, for example, 1.8 times to 2.2 times the equivalent side length. The equivalent edge length is an edge length of a regular pentagon with the same area. The edge lengths of the other edges are at least 5 µm. In a further embodiment, the edge lengths of the other edges are at least 10 µm. In addition, in an optional embodiment, the edge lengths of the other edges are not greater than the edge lengths of the basic input edge and the basic output edge. In addition, a distance between a second endpoint of an input side and a first endpoint of an output side is less than a distance between a first endpoint of the input side and a second endpoint of the output side. An inner angle where the second endpoint of the input side is located is greater than 90° and not greater than 150°, and other inner angles of the convex polygon are not less than 60° and not greater than 150°. An obtuse angle formed by the basic input edge and the basic output edge is not less than 110° and not greater than 170°.

The bulk acoustic wave resonator includes a substrate, an acoustic mirror, a bottom electrode, a top electrode, and a piezoelectric layer. An overlapping region of the acoustic mirror, the bottom electrode, the piezoelectric layer and the top electrode in a thickness direction of the resonator forms an effective region of the resonator.

The bulk acoustic wave resonator according to the present disclosure will be exemplarily described below with reference to the accompanying drawings.

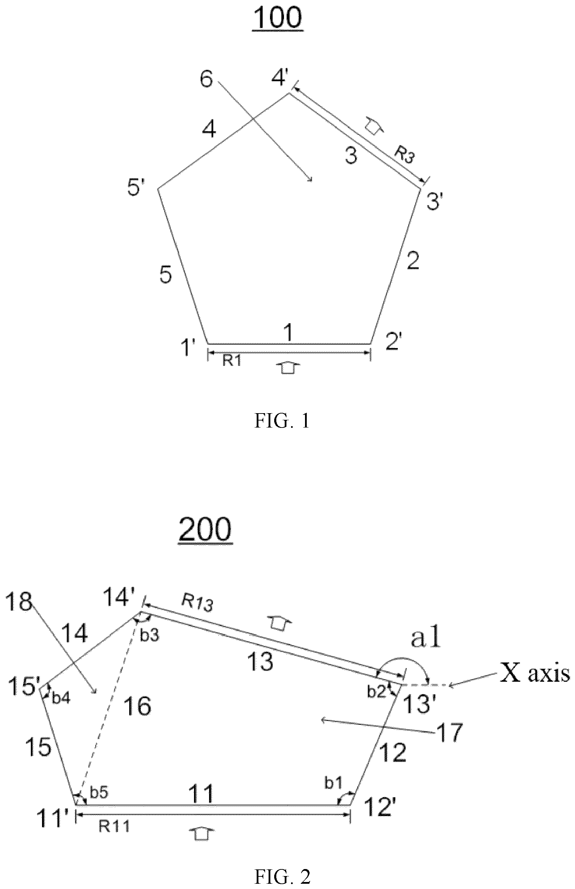

FIG. 1 is a schematic diagram of an equivalent pentagon of an effective region of a bulk acoustic wave resonator. As shown in FIG. 1, a basic structure 100 of the bulk acoustic wave resonator in the present disclosure has a basic shape of a regular pentagon. The regular pentagon is formed by a closed region 6 that is formed by connecting five line segments 1-5 end to end in sequence, and vertices of the regular pentagon are respectively five coordinate points 1' to 5'. In general, the resonator includes at least one input edge and at least one output edge. As shown in FIG. 1, the line segment 1 is configured to be an input edge, and the line segment 3 is configured to be an output edge. The lengths of the two edges are equal, that is, R1=R3. The area of the regular pentagon is set to be S1, such that the edge length R1 or R3 is calculated according to a relationship between the area and the edge length of the regular pentagon: S1 ≈ 1.72 * R1². The R1 or R3 is set to be a basis for subsequent calculation or configuration of the shape of the effective region of the bulk acoustic wave resonator in the present disclosure.

In an embodiment of the present disclosure, the effective region of the bulk acoustic wave resonator is divided into a basic quadrilateral and a plurality of convex regions with four edges used as bottoms, and parameters of the basic quadrilateral are defined. FIGS. 2-5 illustrate examples of the effective region.

FIG. 2 is a top view of an effective region of a bulk acoustic wave resonator according to an exemplary embodiment 200 of the present disclosure. As shown in FIG. 2, the shape of the effective region in the present embodiment is similar to that of the basic structure 100. Five line segments 11-15 are sequentially connected to each other end to end to form a closed region, which is a convex pentagon and of which vertexes are respectively five coordinate points 11'-15'. Compared with the structure 100 in FIG. 1, in the embodiment 200, a length R 11 of an input edge 11 and a length R13 of an output edge 13 are defined to be 1.8 times to 2.2 times the length R1 of the edge length of the basic structure 100, and R11 and R13 may be equal to or different from each other. In addition, an angle B1 formed by the input edge 11 and an edge 12 is required to be greater than 90° and less than or equal to 150°, and an angle a1 (i.e., an obtuse angle formed by the output edge and the input edge) formed by the output edge 13 and the X axis parallel to the input edge is required to be greater than or equal to 110° and less than or equal to 170°. The remaining inner angles b2, b3, b4 and b5 are all required to be greater than or equal to 60° and less than or equal to 150°. In FIG. 2, lengths of the remaining edges 12, 14 and 15 are greater than or equal to 5 µm. In FIG. 2, an effective area of the effective region is the same as the area of the basic structure 100, but its effective region is formed by a basic quadrilateral 17 and a convex region 18 with an edge 16 as a bottom edge.

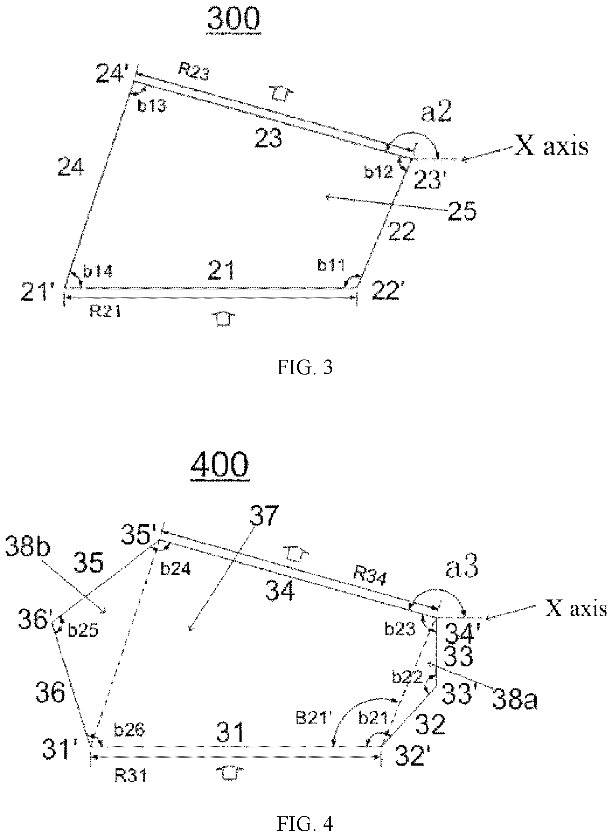

In the embodiment shown in FIG. 2, the shape of the effective region is the convex pentagon, which may not actually be limited to five edges. It is required in the present disclosure that the shape of the effective region of the formed resonator have at least four edges. FIG. 3 shows an embodiment in which the effective region is a quadrilateral.

FIG. 3 is a top view of an effective region of a bulk acoustic wave resonator according to another exemplary embodiment 300 of the present disclosure. As shown in FIG. 3, the shape of the effective region is a quadrilateral, in which a basic quadrilateral directly forms an effective region.

In FIG. 3, the basic quadrilateral 25 is formed of a closed region that is formed by sequentially connecting four line segments 21-24 end to end, and four vertices of the basic quadrilateral are respectively four coordinate points 21'-24'. In FIG. 3, a length R 21 of an input edge 21 and a length R23 of an output edge 23 are defined to be 1.8 times to 2.2 times the length R1 of the edge length of the basic structure 100, and R21 and R23 may be equal to or different from each other. In addition, an angle b11 formed by the input edge 21 and an edge 22 is required to be greater than 90° and less than or equal to 150°, and an angle a2 (i.e., an obtuse angle formed by the output edge and the input edge) formed by the output edge 23 and the X axis parallel to the input edge 21 is required to be greater than or equal to 110° and less than or equal to 170°. The remaining inner angles b12, b13 and b14 are all greater than or equal to 60° and less than or equal to 150°. In FIG. 3, lengths of the remaining edges 22 and 24 are greater than or equal to 5 µm.

The shape of the effective region may be a convex hexagon. FIG. 4 is a top view of an effective region of a bulk acoustic wave resonator according to yet another exemplary embodiment 400 of the present disclosure, in which the effective region is a convex hexagon.

As shown in FIG. 4, the shape of the effective region of the bulk acoustic wave resonator is a hexagon, which is formed of a closed region that is formed by sequentially connecting six line segments 31-36 end to end. Six vertices of the hexagon are six coordinate points 31'-36', respectively. In FIG. 4, a length R31 of an input edge 31 and a length R34 of an output edge 34 are defined to be 1.8 times to 2.2 times the edge length R1 of the basic structure 100, and R31 and R34 may be equal to or different from each other. In addition, in FIG. 4, an angle formed by the input edge 31 and an edge 32 is greater than 90° and not greater than 150°. An angle B21' formed by the input edge 31 and a corresponding edge (a right side edge of the basic quadrilateral in FIG. 4) of the basic quadrilateral is required to be greater than 90° and less than or equal to 135°. An angle a3 formed by the output edge 34 and the X axis parallel to the input edge 31, i.e., an obtuse angle formed by the output edge and the input edge, is greater than or equal to 110° and less than or equal to 170°. The remaining inner angles b22, b23, b24, b25 and b26 of the convex polygon in FIG. 4 are all greater than or equal to 60° and less than or equal to 150°. In the embodiment shown in FIG. 4, lengths of the remaining edges 32, 33, 35 and 36 are greater than or equal to 5 µm. An area of the effective region shown in the embodiment in FIG. 4 is the same as the area of the basic structure 100, but the effective region in FIG. 4 is formed of a basic quadrilateral 37 and outer convex regions 38a and 38b, and two non-input and non-output edges of the basic quadrilateral are used as bottom edges of the outer convex regions.

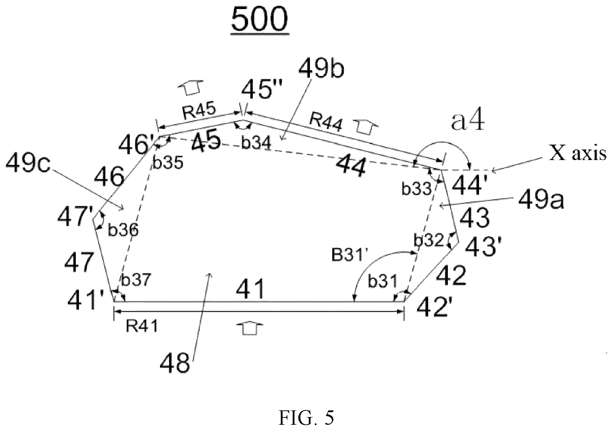

In the embodiments shown in FIGG. 2-4, the input edge and the output edge are both a single edge, but the present disclosure is not limited thereto. For example, the input edge or the output edge may be formed by two short edges or more short edges, such that a plurality of short edges may be regarded as one edge and the one edge forms the input side or the output side. FIG. 5 is a top view of an effective region of a bulk acoustic wave resonator according to yet another exemplary embodiment 500 of the present disclosure, in which the output edge is formed by two short edges.

As shown in FIG. 5, a shape of the effective region of the bulk acoustic wave resonator is a convex heptagon, which is formed of a closed region that is formed by sequentially connecting seven line segments 41-47 end to end. Seven vertices of the heptagon are respectively seven coordinate points 41'-47'. In the embodiment shown in FIG. 5, the output edge includes two edges, that is, an edge 44 and an edge 45. A length R41 of an input edge 41 and the overall length R44 plus R45 of the output edges 44 and 45 are defined to be 1.8 times to 2.2 times the edge length R1 of the basic structure 100, and R41 and the overall length R44 plus R45 may be equal to or different from each other. In addition, in FIG. 5, an angle b31 formed by the input edge 41 and an edge 42 is greater than 90° and not greater than 150°, and an angle B31' formed by the input edge 41 and a corresponding edge (a right side edge of the basic quadrilateral in FIG. 5) of the basic quadrilateral is greater than 90° and less than or equal to 135°. An angle a4 (i.e., an obtuse angle formed by the input edge and a basic output edge) formed by the basic output edge of the basis quadrilateral (an upper edge of the basis quadrilateral in FIG. 5) and the X axis parallel to the input edge 41 is greater than or equal to 110° and less than or equal to 170°, and the remaining inner angles b32, b33, b34, b35, b36 and b37 are all greater than or equal to 60° and less than or equal to 150°. In the embodiment shown in FIG. 5, lengths of the remaining edges 42, 43, 46 and 47 are greater than or equal to 5 µm. An effective area of the effective region shown in the embodiment of FIG. 5 is the same as the area of the basic structure 100, but the effective region is formed of a basic quadrilateral 48 and outer convex regions 49a, 49b, and 49c. The three edges of the basic quadrilateral except the input edge are used as bottom edges of the outer convex regions.

Although not shown in the figures, an outer convex region may be provided on the input side.

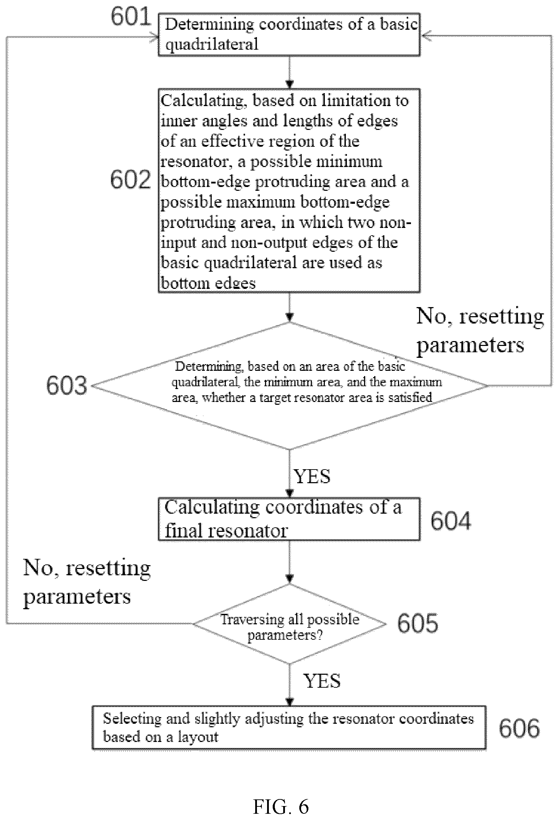

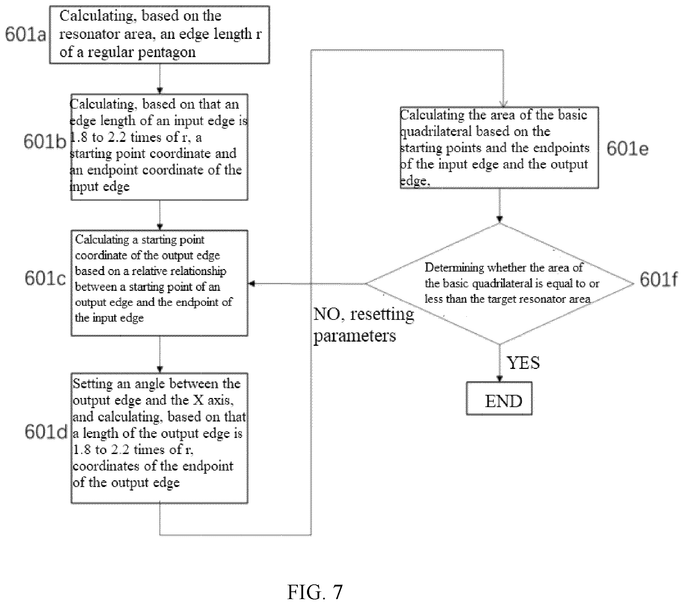

A method for configuring a bulk acoustic wave resonator according to an embodiment of the present disclosure will be described below with reference to FIGS. 6-11. FIG. 6 is a flow diagram of a method for configuring a bulk acoustic wave resonator according to an exemplary embodiment of the present disclosure, and FIG. 7 is a flow diagram of step 601 of determining a basic quadrilateral in FIG. 6 according to an exemplary embodiment of the present disclosure.

The main principle of the configuring method flow shown in FIGS. 6 and 7 is to traverse all possible parameters to calculate possible resonator coordinates, and then finally select and slightly adjust the resonator coordinates according to a layout. More specifically, the shapes of the effective regions of these resonators are selected based on the area of each resonator and an arranging sequence of series resonators and parallel resonators in the final filter or other acoustical devices, as well as a bare chip size of a final product, to preliminarily set the positions. Finally, the purpose of maximally utilizing the area of the substrate is achieved by slightly adjusting the coordinates of each vertex of the effective region of the resonator.

As shown in FIG. 6, the configuring method includes the following steps:
601: determining coordinates of a basic quadrilateral, that is, determining coordinates or positions of four vertices of the basic quadrilateral;
602: calculating, based on limitation to inner angles and lengths of edges of an effective region of the resonator, a possible minimum bottom-edge protruding area and a possible maximum bottom-edge protruding area, in which two non-input and non-output edges of the basic quadrilateral are used as bottom edges;
603: determining, based on an area of the basic quadrilateral, the minimum bottom-edge protruding area, and the maximum bottom-edge protruding area, whether an effective area (that is, a target area) of the effective region is satisfied, and if so, proceeding to step 604, and if not, resetting parameters and returning to step 601;
604: determining, based on the result in 602, coordinates or positions of vertices of a convex polygon of the effective region;
605: reviewing the result obtained in step 604 whether all configuring constraint conditions are satisfied, if not, resetting parameters and returning to step 601, and if so, proceeding to step 606; and
606: when the result obtained in step 604 meets the configuring conditions, selecting, based on the layout, the coordinates or positions of the vertexes of the convex polygon of the effective region of the resonator. If necessary, the coordinates or positions of the vertices of the convex polygon of the effective region may be further adjusted slightly.

It is noted that in step 602, there are definition rules as follows. A distance between a second endpoint of an input side and a first endpoint of an output side is less than a distance between a first endpoint of the input side and a second endpoint of the output side. An inner angle where the second endpoint of the input side is located is greater than 90° and not greater than 150°, and other inner angles of the convex polygon are not less than 60° and not greater than 150°. Edge lengths of other edges except the input side and the output side are greater than or equal to 5 µm.

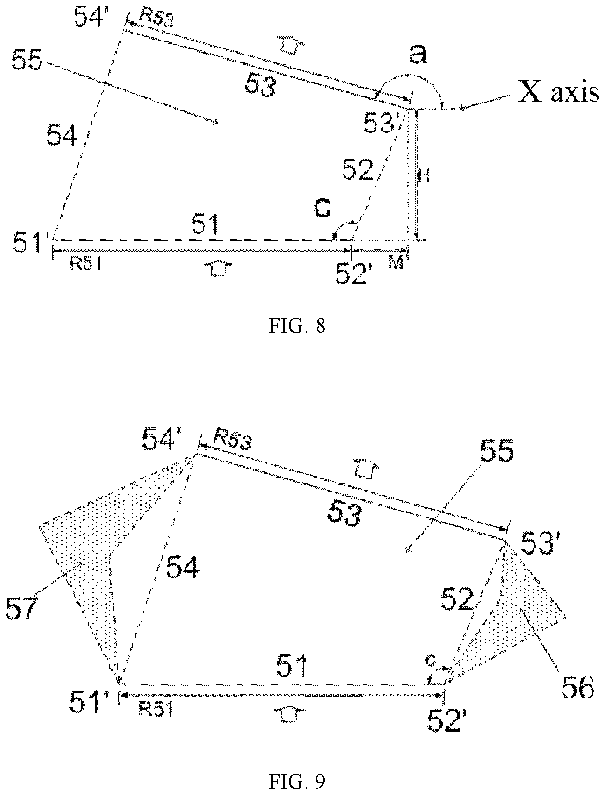

As shown in FIG. 7, step 601 of determining the coordinates of each vertex of the basic quadrilateral includes the following steps:
601a: calculating, based on the target area of the effective region of the bulk acoustic wave resonator, an edge length r of a regular pentagon, the edge length being an equivalent edge length;
601b: calculating, based on that an edge length of an input edge is 1.8 times to 2.2 times the equivalent edge length, a starting point coordinate and an endpoint coordinate of the input edge;
601c: setting a relative relationship between a starting point of an output edge (corresponding to a vertex 53' in FIG. 8) and the endpoint of the input edge (corresponding to a vertex 52' in FIG. 8), for example, determining an angle C in FIG. 8 and a length of an edge 52, and calculating a starting point coordinate of the output edge;
601d: setting an angle between the output edge and the X axis that is parallel to the input edge as shown in FIG. 8, the angle being not less than 110° and not greater than 170° as described above, and calculating, based on that the length of the output edge is 1.8 times to 2.2 times the equivalent edge length, coordinates of the endpoint (corresponding to a vertex 54' in FIG. 8) of the output edge;
601e: calculating, based on the starting point coordinates and the endpoint coordinates of the input edge and the output edge, the area of the basic quadrilateral; and
601f: determining whether the quadrilateral area of the basic quadrilateral is not greater than the effective area or the target area, if so, returning to step 601c to reset the parameters, and if not, determining the position or coordinates of each vertex of the basic quadrilateral.

It should be further noted that, in the decomposition of step 601 shown in FIG. 7, in addition to defining that the area of the basic quadrilateral cannot be greater than the effective area, an obtuse angle formed by the basic input edge (for example, a lower edge of the basic quadrilateral in FIG. 8) and the basic output edge (for example, an upper edge of the basic quadrilateral in FIG. 8) is defined to be not less than 110° and not greater than 170°, and the edge length of the input side and the edge length of the output side are in the range of 1.8 times to 2.2 times the equivalent edge length. In FIG. 8, when the basic quadrilateral is formed, the input side corresponds to the basic input edge, and the output side corresponds to the basic output edge.

FIG. 8 is an example of the basic quadrilateral obtained by step 601 of determining the coordinates of the basic quadrilateral in FIG. 6 and FIG. 7. The basic quadrilateral is formed of a region 55 that is composed of four edges 51-54, and four vertexes of the quadrilateral correspond to coordinate points 51'-54', respectively. The starting point and the endpoint of the input edge 51 are 51' and 52' respectively, and the starting point and the endpoint of the output edge 53 are 53' and 54' respectively. The relative relationship between the endpoint 52' of the input edge 51 and the starting point 53' of the output edge 53 is determined by a height H (FIG. 8) and a translation segment M (FIG. 8) or is determined by the length of the edge 52 and an angle C, and the two relative relationships may be mutually converted.

FIG. 9 shows the minimum bottom-edge protruding area and the maximum bottom-edge protruding area, which are calculated according to step 602 in FIG. 6. Since the distance between the second endpoint of the input side and the first endpoint of the output side is defined to be less than the distance between the first endpoint of the input side and the second endpoint of the output side, the inner angle where the second endpoint of the input side is located is greater than 90° and not greater than 150°, and other inner angles of the convex polygon are not less than 60° and not greater than 150°. Further, the edge lengths of other edges except the input side and the output side are greater than or equal to 5 µm. As for the bottom edge 52, at most only one possible region 56 is used to form an outer convex region of the effective region of the resonator, and the corresponding areas are the minimum area and the maximum area when the edge 52 is used as the bottom edge. Similarly, for the bottom edge 54, at most only one possible region 57 is used to form the outer convex region of the effective region of the resonator, and the corresponding areas are the minimum area and the maximum area when the edge 54 is used as the bottom edge. It should be noted herein that the regions 56 and 57 may not be present or only one may be present.

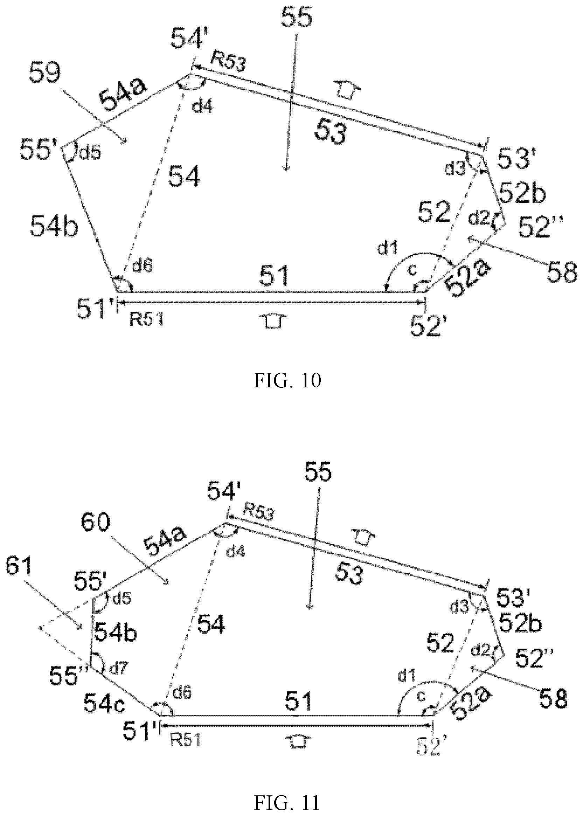

FIG. 10 and FIG. 11 are examples showing shapes which are drawn on the basis of the coordinates of the vertices of the convex polygon of the effective region of the final resonator calculated in step 604, the latter is a shape after the a sharp acute angle of the outer convex region 59 of the former is cut off. That is, the outer convex region 59 in FIG. 10 is cut into an outer convex region 60 and a region 61. Since the region 61 has a sharp corner, the sharp corner may be cut off when the outer convex region seriously deviates from a main channel of radio frequency signals from the input edge 51 to the output edge 53. Thus, in the embodiment in FIG. 10, the final shape of the effective region of the resonator is formed of a basic quadrilateral 55 and outer convex regions 58 and 59. In the embodiment of FIG. 11, the final shape of the effective region of the resonator is formed of the basic quadrilateral 55 and outer convex regions 58 and 60. The corner cutting operation may be performed for multiple times, and the corner cutting operation may be performed on the outer convex region 58 to form a polygon instead of a triangle. In this way, the number of vertices of the effective region of the final resonator is not limited to five, but is limited to be at least four. When only one corner cutting operation is performed, it is required to ensure that the area of the convex region 59 in FIG. 10 is the same as the area of the convex region 60 in FIG. 11. While ensuring the same area, it may be implemented by increasing the inner angles d4 and/or d6 in FIG. 10. In the embodiment where the corner cutting operation is performed on both outer convex regions in FIG. 10, it is required to ensure that the sum of areas of final two outer convex regions is the same as the sum of the areas of the convex regions before performing the corner cutting operation.

In addition, in FIG. 6, the shape of the effective region of the final resonator may be obtained by slightly adjusting the shape of the effective region of the previous resonator. The embodiment 500 shown in FIG. 5 according to the present disclosure may be obtained by slightly adjusting the output edge 53 in FIG. 10, and similarly, the input edge 51 may be slightly adjusted. Therefore, this case should also be included in the present disclosure. It should be noted that, when the shape of the effective region of the final resonator is determined, the definition conditions in step 602 still play a decisive role, that is, the distance between the second endpoint of the input side and the first endpoint of the output side is less than the distance between the first endpoint of the input side and the second endpoint of the output side. Further, the inner angle where the second endpoint of the input side is located is greater than 90° and not greater than 150°, and other inner angles of the convex polygon are not less than 60° and not greater than 150°. The edge lengths of other edges except the input side and the output side are greater than or equal to 5 µm.

In the present disclosure, the main area of the effective region of the resonator is formed of the basic quadrilateral and the convex region of each edge in the presence of the convex region. The basic quadrilateral is a main area of the resonator and its shape determines the general contour of the entire effective area of the resonator. When the length of the effective region of the resonator is relatively small, for example, when a length-to-width ratio of the input/output edge of a device is greater than the equivalent edge length but not greater than 1.5 times the equivalent edge length, a distance between a heat center of the resonator and a silicon substrate or the substrate is equivalent to that of the regular pentagon. Accordingly, the power capacity cannot be improved. When the length-to-width ratio is too large, for example, when the length of the input/output edge is 2.5 times or more the equivalent edge length, the sudden change in impedance of a radio frequency signal occurs when the radio frequency signal enters inside of the resonator from a connecting edge or the input edge. Accordingly, heat of the signal dissipates strongly at the connection or input side, which in turn causes the power capacity to decrease. Therefore, in the edge length configuration of the graph polygon of the effective region of the resonator in the present disclosure, the length of the input edge/output edge is at least 1.5 times to 2.5 times (excluding endpoint values) the equivalent edge length, which is beneficial to obtaining a greater power capacity. For example, when the length of the input edge/output edge of the device is 1.8 times to 2.2 times (including the endpoint values) the equivalent edge length, the basic quadrilateral formed by the edges may be regarded as an equivalent rectangle with a large length-to-width ratio. Since the heat center of the resonator is generally at its geometric center, the short edges of the structure of the present disclosure is configured in such a manner that the distance between the heat center and the silicon substrate or substrate is shorter than that of the regular pentagon. Accordingly, the heat transfer efficiency is higher, thereby achieving a greater power capacity.

Based on the technical solutions of the present disclosure, the length range of each edge of the convex polygon of the effective region, the range of the inner angle, and the range of the obtuse angle formed by the input side and the output side are configured to accurately define the range of the shape of the effective region of the bulk acoustic wave resonator, so as to optimize the shape of the effective region. In this way, on the premise of guaranteeing other performance of the resonator unchanged, the power capacity of the bulk acoustic wave resonator is stably improved, and the performance of the resonator and a bulk acoustic wave device using the resonator are improved.

Based on the method for configuring the shape of the effective region of the bulk acoustic wave resonator provided in the present disclosure, it is possible to automatically calculate coordinate points of the shape of the effective region of the resonator, thereby reducing resource waste of designers, reducing capability requirements for the designers, and improving the design efficiency of bulk acoustic wave devices. In other words, the configuring method of the present disclosure can automatically calculate a possible shape of the resonator, and the developers select an optimal shape based on the layout. Therefore, precise constraints on the shape design of the effective region of the resonator are realized, the design speed is accelerated, and the design efficiency is improved.

In the configuring method of the present disclosure, although the parameters of the basic quadrilateral are defined, the present disclosure allows to slightly adjust the shape of the effective region of the final resonator, which is beneficial to increasing the degree of freedom of the developers.

It should be noted that, in the present disclosure, various numerical ranges, except for explicitly indicating that the endpoint value is not included, may be an endpoint value, or may be a median value of the numerical ranges, and these are all within the protection scope of the present disclosure.

The bulk acoustic wave resonator may be applied to various bulk acoustic wave devices, such as filters, and may also be applied to various electronic devices including the resonators or filters, such as a duplexer, a multiplexer and other electronic devices. The electronic device herein may further include, but is not limited to, intermediate products such as a radio-frequency front end, and a filtering and amplifying module, and terminal products such as a mobile phone, WIFI and an unmanned aerial vehicle.

Based on the above description, the present disclosure provides the following technical solutions.
1. A bulk acoustic wave resonator includes:
   a substrate;
   an acoustic mirror;
   a bottom electrode;
   a top electrode; and
   a piezoelectric layer,
   wherein:
      an overlapping region of the acoustic mirror, the bottom electrode, the piezoelectric layer and the top electrode in a thickness direction of the resonator forms an effective region of the resonator, the effective region has an effective area, and the effective region has a shape of a convex polygon of which a number of edges is equal to or greater than four;
      the convex polygon is divided into a basic quadrilateral and at least one convex region and four edges of the basic quadrilateral are bottom edges of the at least one convex region, or the convex polygon is a basic quadrilateral;
      in the effective region, a second endpoint of an input side, a first endpoint of an output side, a second endpoint of the output side and a first endpoint of the input side are sequentially connected to each other to define the basic quadrilateral, the first endpoint and the second endpoint of the input side define a basic input edge, the first endpoint and the second endpoint of the output side define a basic output edge, and the basic quadrilateral has a quadrilateral area that is equal to or less than the effective area;
      in the convex polygon, a distance between the second endpoint of the input side and the first endpoint of the output side is less than a distance between the first endpoint of the input side and the second endpoint of the output side, an edge length of the input side and an edge length of the output side are in a range of 1.5 times an equivalent edge length to 2.5 times the equivalent edge length, and the equivalent edge length is an edge length of a regular pentagon of which an area is equal to the effective area; and
      an inner angle where the second endpoint of the input side of the convex polygon is located is greater than 90° and equal to or less than 150°, other inner angles of the convex polygon are equal to or greater than 60° and equal to or less than 150°, and an obtuse angle formed by the basic input edge and the basic output edge is equal to or greater than 110° and equal to or less than 170°.
2. The resonator according to claim 1, wherein:
   in the convex polygon, the basic output edge and the basic input edge are an output edge and an input edge of the effective region, respectively.
3. The resonator according to claim 2, wherein:
   in the convex polygon, a straight edge is provided between the second endpoint of the input side and the first endpoint of the output side.
4. The resonator according to claim 3, wherein:
   in the convex polygon, at least two straight edges that are sequentially connected to each other are provided between the first endpoint of the input side and the second endpoint of the output side.
5. The resonator according to claim 2, wherein:
   in the convex polygon, at least two straight edges that are sequentially connected to each other are provided between the second endpoint of the input side and the first endpoint of the output side; and
   in the basic quadrilateral, the inner angle where the second endpoint of the input side is located is greater than 90° and equal to or less than 135°.
6. The resonator according to claim 5, wherein:
   in the convex polygon, at least two straight edges that are sequentially connected to each other are provided between the first endpoint of the input side and the second endpoint of the output side.
7. The resonator according to claim 1, wherein:
   in the convex polygon, the basic input edge is the input edge of the effective region, the output side of the effective region includes at least two output-side straight edges, which are sequentially connected between the first endpoint and the second endpoint of the output side, and the edge length of the output side is the sum of edge lengths of the at least two output-side straight edges; or
   in the convex polygon, the basic output edge is the output edge of the effective region, the input side of the effective area includes at least two input-side straight edges, which are sequentially connected between the first endpoint and the second endpoint of the input side, and the edge length of the input side is the sum of edge lengths of the at least two input-side straight edges; or
   in the convex polygon, the output side of the effective region includes at least two output-side straight edges, which are sequentially connected between the first endpoint and the second endpoint of the output side, the input side of the effective region includes at least two input-side straight edges, which are sequentially connected between the first endpoint and the second endpoint of the input side, the edge length of the input side is the sum of edge lengths of the at least two input-side straight edges, and the edge length of the output side is the sum of edge lengths of the at least two output-side straight edges.
8. The resonator according to claim 1, wherein:
   the quadrilateral area is equal to the effective area.
9. The resonator according to claim 1, wherein:
   the basic input edge and the basic output edge of the basic quadrilateral are both longer than other edges of the basic quadrilateral.
10. The resonator according to claim 1, wherein:
   in the convex polygon, lengths of edges excluding the input side and the output side are equal to or less than the edge lengths of the basic input edge and the basic output edge.
11. The resonator according to claim 1, wherein:
   in the convex polygon, lengths of edges excluding the input side and the output side are equal to or greater than 5 µm.
12. The resonator according to claim 1, wherein:
   the edge length of the input side and the edge length of the output side are in a range of 1.8 times to 2.2 times the equivalent edge length.
13. A method for configuring a bulk acoustic wave resonator, wherein the resonator includes a substrate, an acoustic mirror, a bottom electrode, a top electrode, and a piezoelectric layer, wherein an overlapping region of the acoustic mirror, the bottom electrode, the piezoelectric layer and the top electrode in a thickness direction of the resonator forms an effective region of the resonator, a shape of the effective region is a convex polygon of which a number of edges is equal to or greater than four, the convex polygon is divided into a basic quadrilateral and at least one convex region and four edges of the basic quadrilateral are bottom edges of the at least one convex region, or the convex polygon is a basic quadrilateral, and the method includes steps of:
   determining an effective area of the effective region, and obtaining an equivalent edge length of the effective region, the equivalent edge length being an edge length of a regular pentagon of which an area is equal to the effective area; and
   selecting positions of a first endpoint and a second endpoint of a basic input edge and selecting positions of a first endpoint and a second endpoint of a basic output edge to determine the basic quadrilateral,
   wherein an edge length of an input side and an edge length of an output side are in a range of 1.5 times the equivalent edge length to 2.5 times the equivalent edge length, an obtuse angle formed by the basic input edge and the basic output edge is equal to or greater than 110° and equal to or less than 170°, and an quadrilateral area of the basic quadrilateral is equal to or less than the effective area;
   wherein the first endpoint and the second endpoint of the basic input edge are the first endpoint and the second endpoint of the input side of the effective region, the first endpoint and the second endpoint of the basic output edge are the first endpoint and the second endpoint of the output side of the effective region, and a distance between the second endpoint of the input side and the first endpoint of the output side is less than a distance between the first endpoint of the input side and the second endpoint of the output side; and
   wherein in the convex polygon, an inner angle where the second endpoint of the input side of the convex polygon is located is greater than 90° and equal to or less than 150°, and other inner angles of the convex polygon are equal to or greater than 60° and equal to or less than 150°.
14. The method according to claim 13, includes steps of:
   when the quadrilateral area is less than the effective area, configuring at least one of two edges excluding the basic input edge and the basic output edge of the basic quadrilateral to be a bottom edge, and calculating a maximum bottom-edge protruding area and a minimum bottom-edge protruding area, which protrude from the bottom edge; and
   selecting a corresponding bottom-edge protruding area from the maximum bottom-edge protruding area and the minimum bottom-edge protruding area in such a manner that the sum of all bottom-edge protruding areas and the quadrilateral area is equal to the effective area.
15. The method according to claim 14, wherein:
   the minimum bottom-edge protruding area is zero.
16. The method according to claim 14, wherein:
   an edge that is defined by the second endpoint of the input side and the first endpoint of the output side is configured to be the bottom edge, to calculate the maximum bottom-edge protruding area and the minimum bottom-edge protruding area that protrude from the bottom edge; and
   the basic input edge and the bottom edge that is defined by the second endpoint of the input side and the first endpoint of the output side form an inner angle of the basic quadrilateral, which is greater than 90° and equal to or less than 135°.
17. The method according to claim 13, includes steps of:
   when the quadrilateral area is less than the effective area, configuring at least one of two edges excluding the basic input edge and the basic output edge of the basic quadrilateral to be a bottom edge, and calculating a maximum bottom-edge protruding area and a minimum bottom-edge protruding area, which protrude from the bottom edge;
   selecting a corresponding bottom-edge protruding area from the maximum bottom-edge protruding area and the minimum bottom-edge protruding area; and
   forming the basic input edge and/or the basic output edge of the basic quadrilateral to protrude outwards to form a basic-edge protruding area, in such a manner that the sum of all bottom-edge protruding areas, all basic-edge protruding areas and the quadrilateral area is equal to the effective area.
18. The method according to claim 13, includes steps of:
   when the quadrilateral area is equal to the effective area, configuring the basic quadrilateral to be the convex polygon, in such a manner that lengths of the edges excluding the basic input edge and the basic output edge of the basic quadrilateral are equal to or greater than 5 µm, an inner angle where the second endpoint of the basic input edge of the basic quadrilateral is located is greater than 90° and equal to or less than 150°, and other inner angles of the basic quadrilateral are equal to or greater than 60° and equal to or less than 150°.
19. The method according to claim 13, wherein:
   in the convex polygon, lengths of the edges excluding the input side and the output side are equal to or greater than 5 µm.
20. The method according to claim 13, wherein:
   the edge length of the input side and the edge length of the output side are in a range of 1.8 times to 2.2 times the equivalent edge length.
21. The method according to any one of claims 13-20, wherein the step of determining the basic quadrilateral includes:
   step 1: configuring a length in a range of 1.5 times the equivalent edge length to 2.5 times the equivalent edge length to be the length of the basic input edge, and determining coordinates or positions of the first endpoint and the second endpoint of the basic input edge;
   step 2: setting coordinates or a position of the first endpoint of the basic output edge;
   step 3: configuring the length in the range of 1.5 times the equivalent edge length to 2.5 times the equivalent edge length to be the length of the basic output edge, and determining coordinates or a position of the second endpoint of the basic output edge in such a manner that an obtuse angle formed by the basic input edge and the basic output edge is equal to or greater than 110° and equal to or less than 170°;
   step 4: calculating, based on the coordinates or positions of the first endpoint and the second endpoint of the basic input edge and the coordinates or positions of the first endpoint and the second endpoint of the basic output edge, the quadrilateral area of the basic quadrilateral; and
   step 5: determining that the basic quadrilateral is a final basic quadrilateral if the quadrilateral area is equal to or less than the effective area, or returning to step 2 if the quadrilateral area is greater than the effective area.
22. The method according to claim 21, wherein:
   determining, based on an edge length of the bottom edge defined by the second endpoint of the input side and the first endpoint of the output side and the inner angle of the basic quadrilateral formed by the bottom edge and the basic input edge, the coordinates or position of the first endpoint of the basic output edge; or
   determining, based on an extension length of an extension segment of the basic input edge extending from the second endpoint of the basic input edge and an extension length of another extension segment perpendicular to the extension segment, the coordinates or position of the first endpoint of the basic output edge.
23. A filter includes at least one bulk acoustic wave resonator according to any one of claims 1-13.
24. An electronic device includes the filter according to claim 23 or the bulk acoustic wave resonator according to any one of claims 1-13.

It should be noted that, the electronic device herein includes, but is not limited to, intermediate products such as a radio-frequency front end and a filtering and amplifying module, and terminal products such as a mobile phone, WIFI and an unmanned aerial vehicle.

Although the embodiments of the present disclosure have been shown and described, it will be understood by those of ordinary skilled in the art that changes may be made to these embodiments without departing from the principles and spirit of the present disclosure, and the scope of the present disclosure is determined by the appended claims and their equivalents.

## Claims

1. A bulk acoustic wave resonator, comprising:
a substrate;
an acoustic mirror;
a bottom electrode;
a top electrode; and
a piezoelectric layer,
wherein an overlapping region of the acoustic mirror, the bottom electrode, the piezoelectric layer and the top electrode in a thickness direction of the resonator forms an effective region of the resonator, the effective region has an effective area, and the effective region has a shape of a convex polygon of which a number of edges is equal to or greater than four;
wherein the convex polygon is divided into a basic quadrilateral and at least one convex region and four edges of the basic quadrilateral are bottom edges of the at least one convex region, or the convex polygon is a basic quadrilateral;
wherein in the effective region, a second endpoint of an input side, a first endpoint of an output side, a second endpoint of the output side and a first endpoint of the input side are sequentially connected to each other to define the basic quadrilateral, the first endpoint and the second endpoint of the input side define a basic input edge, the first endpoint and the second endpoint of the output side define a basic output edge, and the basic quadrilateral has a quadrilateral area that is equal to or less than the effective area;
wherein in the convex polygon, a distance between the second endpoint of the input side and the first endpoint of the output side is less than a distance between the first endpoint of the input side and the second endpoint of the output side, an edge length of the input side and an edge length of the output side are in a range of 1.5 times an equivalent edge length to 2.5 times the equivalent edge length, and the equivalent edge length is an edge length of a regular pentagon of which an area is equal to the effective area; and
wherein an inner angle where the second endpoint of the input side of the convex polygon is located is greater than 90° and equal to or less than 150°, other inner angles of the convex polygon are equal to or greater than 60° and equal to or less than 150°, and an obtuse angle formed by the basic input edge and the basic output edge is equal to or greater than 110° and equal to or less than 170°.

2. The resonator according to claim 1, wherein in the convex polygon, the basic output edge and the basic input edge are an output edge and an input edge of the effective region, respectively.

3. The resonator according to claim 2, wherein in the convex polygon, a straight edge is provided between the second endpoint of the input side and the first endpoint of the output side.

4. The resonator according to claim 3, wherein in the convex polygon, at least two straight edges that are sequentially connected to each other are provided between the first endpoint of the input side and the second endpoint of the output side.

5. The resonator according to claim 2, wherein in the convex polygon, at least two straight edges that are sequentially connected to each other are provided between the second endpoint of the input side and the first endpoint of the output side; and
in the basic quadrilateral, the inner angle where the second endpoint of the input side is located is greater than 90° and equal to or less than 135°.

6. The resonator according to claim 5, wherein in the convex polygon, at least two straight edges that are sequentially connected to each other are provided between the first endpoint of the input side and the second endpoint of the output side.

7. The resonator according to claim 1, wherein in the convex polygon, the basic input edge is the input edge of the effective region, the output side of the effective region comprises at least two output-side straight edges, which are sequentially connected between the first endpoint and the second endpoint of the output side, and the edge length of the output side is the sum of edge lengths of the at least two output-side straight edges; or
in the convex polygon, the basic output edge is the output edge of the effective region, the input side of the effective area comprises at least two input-side straight edges, which are sequentially connected between the first endpoint and the second endpoint of the input side, and the edge length of the input side is the sum of edge lengths of the at least two input-side straight edges; or
in the convex polygon, the output side of the effective region comprises at least two output-side straight edges, which are sequentially connected between the first endpoint and the second endpoint of the output side, the input side of the effective region comprises at least two input-side straight edges, which are sequentially connected between the first endpoint and the second endpoint of the input side, the edge length of the input side is the sum of edge lengths of the at least two input-side straight edges, and the edge length of the output side is the sum of edge lengths of the at least two output-side straight edges.

8. The resonator according to claim 1, wherein the quadrilateral area is equal to the effective area.

9. The resonator according to claim 1, wherein the basic input edge and the basic output edge of the basic quadrilateral are both longer than other edges of the basic quadrilateral.

10. The resonator according to claim 1, wherein in the convex polygon, lengths of edges excluding the input side and the output side are equal to or less than the edge lengths of the basic input edge and the basic output edge.

11. The resonator according to claim 1, wherein in the convex polygon, lengths of edges excluding the input side and the output side are equal to or greater than 5 µm.

12. The resonator according to claim 1, wherein the edge length of the input side and the edge length of the output side are in a range of 1.8 times to 2.2 times the equivalent edge length.

13. A method for configuring a bulk acoustic wave resonator, wherein the resonator comprises a substrate, an acoustic mirror, a bottom electrode, a top electrode, and a piezoelectric layer, an overlapping region of the acoustic mirror, the bottom electrode, the piezoelectric layer and the top electrode in a thickness direction of the resonator forms an effective region of the resonator, a shape of the effective region is a convex polygon of which a number of edges is equal to or greater than four, the convex polygon is divided into a basic quadrilateral and at least one convex region and four edges of the basic quadrilateral are bottom edges of the at least one convex region, or the convex polygon is a basic quadrilateral, and the method comprises:
determining an effective area of the effective region, and obtaining an equivalent edge length of the effective region, the equivalent edge length being an edge length of a regular pentagon of which an area is equal to the effective area; and
selecting positions of a first endpoint and a second endpoint of a basic input edge and selecting positions of a first endpoint and a second endpoint of a basic output edge to determine the basic quadrilateral,
wherein an edge length of an input side and an edge length of an output side are in a range of 1.5 times the equivalent edge length to 2.5 times the equivalent edge length, an obtuse angle formed by the basic input edge and the basic output edge is equal to or greater than 110° and equal to or less than 170°, and an quadrilateral area of the basic quadrilateral is equal to or less than the effective area;
wherein the first endpoint and the second endpoint of the basic input edge are the first endpoint and the second endpoint of the input side of the effective region, the first endpoint and the second endpoint of the basic output edge are the first endpoint and the second endpoint of the output side of the effective region, and a distance between the second endpoint of the input side and the first endpoint of the output side is less than a distance between the first endpoint of the input side and the second endpoint of the output side; and
wherein in the convex polygon, an inner angle where the second endpoint of the input side of the convex polygon is located is greater than 90° and equal to or less than 150°, and other inner angles of the convex polygon are equal to or greater than 60° and equal to or less than 150°.

14. The method according to claim 13, further comprising:
when the quadrilateral area is less than the effective area, configuring at least one of two edges excluding the basic input edge and the basic output edge of the basic quadrilateral to be a bottom edge, and calculating a maximum bottom-edge protruding area and a minimum bottom-edge protruding area, which protrude from the bottom edge; and
selecting a corresponding bottom-edge protruding area from the maximum bottom-edge protruding area and the minimum bottom-edge protruding area in such a manner that the sum of all bottom-edge protruding areas and the quadrilateral area is equal to the effective area.

15. The method according to claim 14, wherein the minimum bottom-edge protruding area is zero.

16. The method according to claim 14, wherein an edge that is defined by the second endpoint of the input side and the first endpoint of the output side is configured to be the bottom edge, to calculate the maximum bottom-edge protruding area and the minimum bottom-edge protruding area that protrude from the bottom edge; and
the basic input edge and the bottom edge that is defined by the second endpoint of the input side and the first endpoint of the output side form an inner angle of the basic quadrilateral, which is greater than 90° and equal to or less than 135°.

17. The method according to claim 13, further comprising:
when the quadrilateral area is less than the effective area, configuring at least one of two edges excluding the basic input edge and the basic output edge of the basic quadrilateral to be a bottom edge, and calculating a maximum bottom-edge protruding area and a minimum bottom-edge protruding area, which protrude from the bottom edge;
selecting a corresponding bottom-edge protruding area from the maximum bottom-edge protruding area and the minimum bottom-edge protruding area; and
forming the basic input edge and/or the basic output edge of the basic quadrilateral to protrude outwards to form a basic-edge protruding area, in such a manner that the sum of all bottom-edge protruding areas, all basic-edge protruding areas and the quadrilateral area is equal to the effective area.

18. The method according to claim 13, further comprising:
when the quadrilateral area is equal to the effective area, configuring the basic quadrilateral to be the convex polygon, in such a manner that lengths of the edges excluding the basic input edge and the basic output edge of the basic quadrilateral are equal to or greater than 5 µm, an inner angle where the second endpoint of the basic input edge of the basic quadrilateral is located is greater than 90° and equal to or less than 150°, and other inner angles of the basic quadrilateral are equal to or greater than 60° and equal to or less than 150°.

19. The method according to claim 13, wherein in the convex polygon, lengths of the edges excluding the input side and the output side are equal to or greater than 5 µm.

20. The method according to claim 13, wherein the edge length of the input side and the edge length of the output side are in a range of 1.8 times to 2.2 times the equivalent edge length.

21. The method according to any one of claims 13-20, wherein the determining the basic quadrilateral comprises:
step 1: configuring a length in a range of 1.5 times the equivalent edge length to 2.5 times the equivalent edge length to be the length of the basic input edge, and determining coordinates or positions of the first endpoint and the second endpoint of the basic input edge;
step 2: setting coordinates or a position of the first endpoint of the basic output edge;
step 3: configuring the length in the range of 1.5 times the equivalent edge length to 2.5 times the equivalent edge length to be the length of the basic output edge, and determining coordinates or a position of the second endpoint of the basic output edge in such a manner that an obtuse angle formed by the basic input edge and the basic output edge is equal to or greater than 110° and equal to or less than 170°;
step 4: calculating, based on the coordinates or positions of the first endpoint and the second endpoint of the basic input edge and the coordinates or positions of the first endpoint and the second endpoint of the basic output edge, the quadrilateral area of the basic quadrilateral; and
step 5: determining that the basic quadrilateral is a final basic quadrilateral if the quadrilateral area is equal to or less than the effective area, or returning to step 2 if the quadrilateral area is greater than the effective area.

22. The method according to claim 21, comprising:
determining, based on an edge length of the bottom edge defined by the second endpoint of the input side and the first endpoint of the output side and the inner angle of the basic quadrilateral formed by the bottom edge and the basic input edge, the coordinates or position of the first endpoint of the basic output edge; or
determining, based on an extension length of an extension segment of the basic input edge extending from the second endpoint of the basic input edge and an extension length of another extension segment perpendicular to the extension segment, the coordinates or position of the first endpoint of the basic output edge.

23. A filter, comprising at least one bulk acoustic wave resonator according to any one of claims 1-13.

24. An electronic device, comprising the filter according to claim 23 or the bulk acoustic wave resonator according to any one of claims 1-13.
